# EUROPEAN PATENT APPLICATION

(11) **EP 4 618 137 A1**
(43) Date of publication of application: **17.09.2025**
(21) Application number: 23888019.9
(22) Date of filing: 07.11.2023
(51) Int. Cl.: H01L 21/66

(54) **SILICON WAFER SIDE EDGE DETECTION DEVICE AND SILICON WAFER SORTING MACHINE**

(30) Priority: 13.11.2022 CN 202223011187 U
(71) Applicant: Wuxi Autowell Technology Co., Ltd., Wuxi, Jiangsu 214000 (CN)
(72) Inventor: YAN, Dong, Wuxi, Jiangsu 214000 (CN); LI, Chang, Wuxi, Jiangsu 214000 (CN); HONG, Rui, Wuxi, Jiangsu 214000 (CN); WANG, Mei, Wuxi, Jiangsu 214000 (CN); XU, Fei, Wuxi, Jiangsu 214000 (CN); BIAN, Haifeng, Wuxi, Jiangsu 214000 (CN); XIAO, Wenlong, Wuxi, Jiangsu 214000 (CN); LI, Zetong, Wuxi, Jiangsu 214000 (CN); XUE, Dongdong, Wuxi, Jiangsu 214000 (CN); GU, Xiaoyi, Wuxi, Jiangsu 214000 (CN); HAN, Jie, Wuxi, Jiangsu 214000 (CN)
(74) Representative: Winter, Brandl - Partnerschaft mbB
(86) International application number: PCT/CN2023/130293
(87) International publication number: WO 2024/099330

(57) **Abstract**

The present disclosure discloses a silicon wafer side edge detection device, comprising a first detection unit and a second detection unit, wherein the first detection unit and the second detection unit are of the same structure and are respectively configured to detect two mutually parallel side edges of a silicon wafer; and the first detection unit and the second detection unit each comprises a side edge detection assembly, the side edge detection assembly comprising a first point light source, a first optical path defining element, and a camera, wherein the first optical path defining element comprises a reflective structure and a slit, the reflective structure is configured to reflect light emitted by the first point light source and reflect the light to a side edge of a silicon wafer to be detected, and the light is reflected by the side edge of the silicon wafer to be detected and passes through the slit into the camera. The present disclosure not only solves the problem of an existing square prism affecting an imaging effect, but improves the imaging effect. The mounting of the first optical path defining element is also more convenient than the mounting of the square prism, so that it is more suitable for large-scale industrial use.

## Description

### TECHNICAL FIELD

The present disclosure relates to the field of silicon wafer sorting, and specifically relates to a silicon wafer side edge detection device and a silicon wafer sorting machine.

### BACKGROUND ART

Before a silicon wafer is made into a cell, it is necessary to perform a series of defect detections on the silicon wafer, one of which is to detect a side edge of the silicon wafer.

In existing detection methods, a square prism is mostly used to reflect or transmit light from a light source, and part of the light transmitted by the square prism is reflected by a bottom of the square prism again, resulting in a too bright photographic background, which affects an imaging effect, thereby causing interference to side edge detection.

### SUMMARY OF THE INVENTION

In view of the problem of the use of a square prism for current side edge detection affecting an imaging effect, the present disclosure provides a silicon wafer side edge detection device and a silicon wafer sorting machine.

In a first aspect, the present disclosure provides a silicon wafer side edge detection device, comprising a first detection unit and a second detection unit, wherein the first detection unit and the second detection unit are of the same structure and are respectively configured to detect two mutually parallel side edges of a silicon wafer; and
the first detection unit and the second detection unit each comprises a side edge detection assembly, the side edge detection assembly comprising a first point light source, a first optical path defining element, and a camera, wherein the first optical path defining element comprises a reflective structure and a slit, the reflective structure is configured to reflect light emitted by the first point light source and reflect the light to a side edge of a silicon wafer to be detected, and the light is reflected by the side edge of the silicon wafer to be detected and passes through the slit into the camera.

By using the reflective structure of the first optical path defining element to reflect the light emitted by the first point light source, reflecting the light to the side edge of the silicon wafer to be detected, and using the slit of the first optical path defining element to receive the light reflected back from the side edge of the silicon wafer to be detected, the light reflected from the side edge of the silicon wafer to be detected passes through the slit into the camera to achieve photographic detection of the side edge of the silicon wafer, so that not only is the problem of an existing square prism affecting an imaging effect solved, but the imaging effect is also improved. Moreover, the mounting of the first optical path defining element is also more convenient than the mounting of the square prism, so that it is more suitable for large-scale industrial use.

Optionally, the camera and the first optical path defining element are arranged collinearly, and an optical axis of the camera corresponds to the slit; and the first point light source is arranged directly above the reflective structure.

The camera and the first optical path defining element are arranged collinearly, and the optical axis of the camera corresponds to the slit, so that the light reflected from the side edge of the silicon wafer to be detected can linearly pass through the slit into the camera, the imaging effect of the camera can further be improved, and an optical path for the detection is simpler to debug. The first point light source is arranged directly above the reflective structure, so that the light emitted by the first point light source can be directly directed to the reflective structure without multiple reflections, and the optical path is simpler and easy to mount and debug.

Optionally, the first optical path defining element further comprises a first mounting base in the shape of a right triangular prism, and the reflective structure is fixed to an inclined surface of the first mounting base.

By designing the first mounting base in the shape of a right triangular prism, not only is the machining facilitated, but fixing the reflective structure to the inclined surface of the first mounting base at a certain angle is also facilitated.

Optionally, the reflective structure comprises a first reflective structure and a second reflective structure which are symmetrically fixed on two sides of the slit.

The light from the first point light source is reflected by using the first reflective structure and the second reflective structure, so that the light reflected to the side edges of the silicon wafer to be detected can effectively be increased, the side edges can then reflect back more light into the camera through the slit, a better imaging effect can be achieved, and thus a side edge detection effect can be improved. Furthermore, the first reflective structure and the second reflective structure are symmetrically fixed on the two sides of the slit, so that the utilization rate of the light source can effectively be improved.

Optionally, an inner cavity of the first optical path defining element is a blackened inner cavity, and the inner cavity comprises an inner wall of the slit and/or a back surface of the reflective structure.

By blackening the inner cavity of the first optical path defining element, part of the light entering the inner cavity can be absorbed, so as to avoid undesired reflection and refraction of the light in the inner cavity, which otherwise affects the imaging effect.

Optionally, the first detection unit and the second detection unit each further comprise a first chamfer detection assembly and a second chamfer detection assembly, and the first chamfer detection assembly and the second chamfer detection assembly are of the same structure, and are symmetrically arranged relative to the side edge detection assembly; and the first chamfer detection assembly and the second chamfer detection assembly each comprise a second optical path defining element, the second optical path defining element comprising a second mounting base, a third reflective structure, a fourth reflective structure and a channel, wherein the channel is arranged on the second mounting base and is configured to provide a conveying channel for the silicon wafer to be detected, and the third reflective structure and the fourth reflective structure are fixedly arranged on two sides of the channel respectively.

By providing the chamfer detection assemblies, in addition to the detection of the side edges of the silicon wafer, the silicon wafer side edge detection device of the present disclosure can also detect the chamfers connected to the side edges. The chamfers of the silicon wafer to be detected are detected by using the second optical path defining element having the third reflective structure, the fourth reflective structure and the channel.

Optionally, the first chamfer detection assembly and the second chamfer detection assembly each further comprise a second point light source, the third reflective structure and the fourth reflective structure are configured to reflect light emitted by the respective second point light source and reflect the light to a chamfer of the silicon wafer to be detected, and the light is reflected by the chamfer of the silicon wafer to be detected and passes through the slit into the camera.

The second point light source is arranged to provide illumination for the third reflective structure and the fourth reflective structure so as to complete the imaging of the chamfers of the silicon wafer to be detected, so that a better imaging effect can be obtained.

Optionally, the second mounting base is in the shape of a right triangular prism, and the third reflective structure and the fourth reflective structure are fixedly arranged on an inclined surface of the second mounting base.

By designing the second mounting base to be in the shape of a right triangular prism, not only is the machining facilitated, but fixing the third reflective structure and the fourth reflective structure to the inclined surface of the second mounting base at a certain angle is also facilitated.

Optionally, the channel is a blind slot or a through slot extending horizontally from the inclined surface of the second mounting base to the interior of the second mounting base.

The blind slot or the through slot extending horizontally from the inclined surface of the second mounting base to the interior of the second mounting base provides a channel for allowing the side edges and the chamfers of the silicon wafer to pass through in the silicon wafer detection process, thus providing a necessary condition for detecting the silicon wafer while the silicon wafer is being moved.

Optionally, the first detection unit and the second detection unit are each adjustable toward or away from the silicon wafer to be detected.

By designing each of the first detection unit and the second detection unit to be adjustable toward or away from the silicon wafer to be detected, not only are mounting and debugging facilitated, but the compatibility with silicon wafers of different sizes is also facilitated.

Optionally, the first detection unit and the second detection unit are respectively arranged corresponding to the two mutually parallel side edges of the silicon wafer to be detected, and are distributed in a staggered manner in an extending direction of the side edges.

By arranging the first detection unit and the second detection unit in a staggered manner, mutual interference between the two detection units can be avoided, and the detection accuracy can be improved.

In a second aspect, the present disclosure provides a silicon wafer sorting machine, comprising a silicon wafer side edge detection device as described above and an alignment device, wherein the alignment device is located upstream of the silicon wafer side edge detection device and is configured to pre-align the silicon wafer to be detected that enters the silicon wafer side edge detection device.

Before the side edges of the silicon wafer are detected, the silicon wafer is pre-aligned by using the alignment device, so that the silicon wafer is kept in a preferred positional state when reaching the silicon wafer side edge detection device, so that the effect and efficiency of side edge detection can further be improved, and the overall efficiency of the silicon wafer sorting machine can thus be improved.

### BRIEF DESCRIPTION OF THE DRAWINGS

FIG. 1 is a schematic diagram of an implementation of a silicon wafer side edge detection device;
FIG. 2 is a schematic diagram of an implementation of a first chamfer detection assembly of a first detection unit;
FIG. 3 is a schematic diagram of an implementation of the first detection unit;
FIG. 4 is a front view of FIG. 3;
FIG. 5 is a schematic diagram of an implementation of a first optical path defining element of the first detection unit;
FIG. 6 is a schematic diagram of an implementation of a second optical path defining element of the first chamfer detection assembly of the first detection unit;
FIG. 7 is a schematic diagram of an implementation of a second optical path defining element of a second chamfer detection assembly of the first detection unit; and
FIG. 8 is a schematic diagram of another implementation of the silicon wafer side edge detection device.

In the figures: first detection unit 1, first point light source 11, first optical path defining element 12, reflective structure 121, first reflective structure 1211, second reflective structure 1212, slit 122, first mounting base 123, and camera 13;
first chamfer detection assembly 14, second optical path defining element 141, second mounting base 1411, third reflective structure 1412, fourth reflective structure 1413, channel 1414, and second point light source 142;
second chamfer detection assembly 15, second optical path defining element 151, second mounting base 1511, third reflective structure 1512, fourth reflective structure 1513, channel 1514, and second point light source 152;
second detection unit 2, first point light source 21, camera 23, first chamfer detection assembly 24, and second chamfer detection assembly 25; and
silicon wafer 100, first side edge 110, second side edge 120, first connecting plate 3, second connecting plate 4, and adjustment track 5.

### DETAILED DESCRIPTION OF EMBODIMENTS

To make the objective, technical solutions and advantages of embodiments of the present disclosure clearer, the technical solutions in the present disclosure are clearly and completely described below with reference to the accompanying drawings in the embodiments of the present disclosure. The described embodiments are some rather than all of the embodiments of the present disclosure. Thus, the following detailed description of the embodiments of the present disclosure provided in the accompanying drawings is not intended to limit the scope of the present disclosure as claimed, but is merely representative of the selected embodiments of the present disclosure.

The present disclosure is described in detail below with reference to the accompanying drawings and the embodiments. It should be noted that the embodiments in the present disclosure and features in the embodiments may be combined with each other without conflicts.

In existing chip surface detection, a dome reflective mirror is used to reflect light from a light source onto a surface of a chip. Such a dome light source has the advantages of a large illumination area and good uniformity, but this method is not suitable for adjusting a specific optical path direction and has strict requirements for a working distance. If the dome light source is used to detect a side edge of a silicon wafer, due to a small working distance required by the light source, there are strict requirements for a mounting space, and it is very difficult to mount the light source. In addition, since there are saw marks on the side edge of the silicon wafer after cutting, if the dome light source is used, based on the good uniformity of the light source, the saw marks are also imaged in the field of view of a camera, which is very detrimental to analysis of actual defects.

In current detection of the side edge of the silicon wafer, a square prism is mostly used to reflect or transmit light from a light source, and part of the light transmitted by the square prism is reflected by a bottom of the square prism again, resulting in a too bright photographic background, which affects an imaging effect, thereby causing interference to side edge detection.

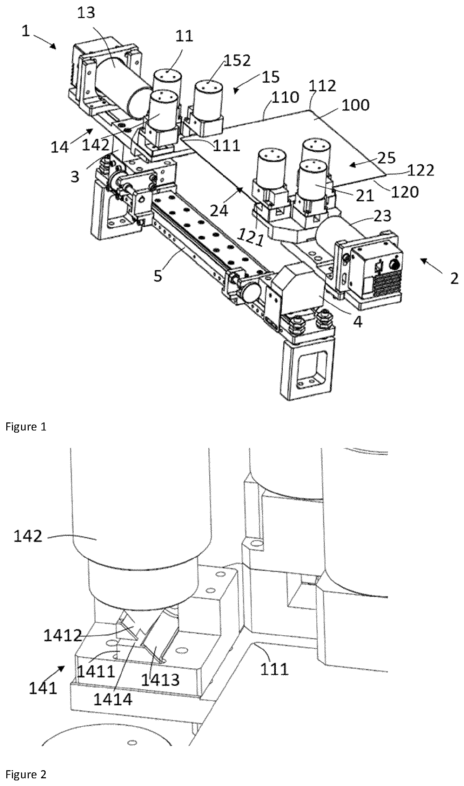

In view of the problem of the use of a square prism for current side edge detection affecting an imaging effect, in a first aspect, as shown in FIG. 1, the present disclosure provides a silicon wafer side edge detection device, comprising a first detection unit 1 and a second detection unit 2. The first detection unit 1 and the second detection unit 2 are of the same structure, and are respectively configured to detect two mutually parallel side edges of a silicon wafer 100, that is, a first side edge 110 and a second side edge 120. Two chamfers connected to the first side edge 110 are a first chamfer 111 and a second chamfer 112 respectively, and two chamfers connected to the second side edge 120 are a first chamfer 121 and a second chamfer 122 respectively.

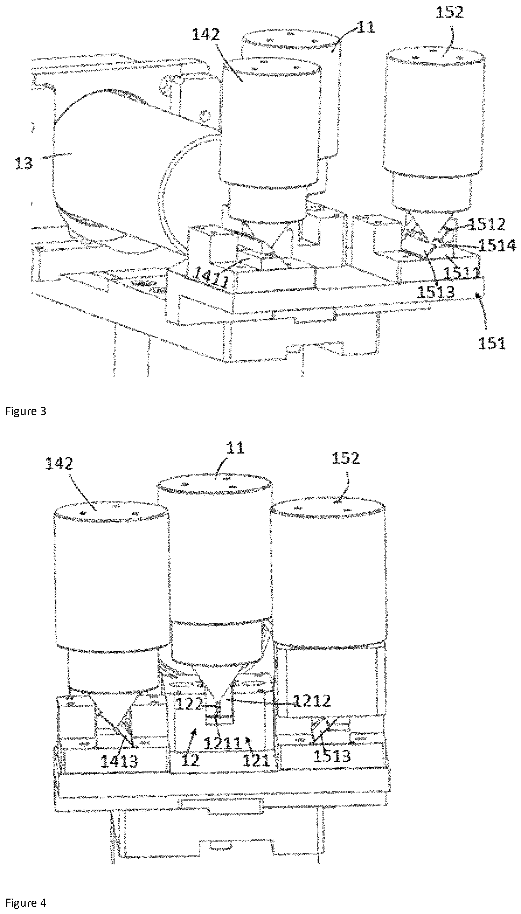

The first detection unit 1 and the second detection unit 2 each comprises a side edge detection assembly. As shown in FIGS. 1 and 4, the side edge detection assembly of the first detection unit 1 comprises a first point light source 11, a first optical path defining element 12, and a camera 13, The first optical path defining element 12 comprises a reflective structure 121 and a slit 122. The reflective structure 121 is configured to reflect light emitted by the first point light source 11 and reflect the light to the respective side edge of the silicon wafer 100 to be detected, and the light is reflected by the side edge of the silicon wafer 100 to be detected and passes through the slit 122 into the camera 13.

Similarly, as shown in FIG. 1, the side edge detection assembly of the second detection unit also comprises a first point light source 21, a first optical path defining element, and a camera 23. The first optical path defining element (not shown in FIG. 1) comprises a reflective structure and a slit. The reflective structure is configured to reflect light emitted by the first point light source and reflect the light to the respective side edge of the silicon wafer 100 to be detected, and the light is reflected by the side edge of the silicon wafer 100 to be detected and passes through the slit into the camera.

It should be noted that the camera used in the present disclosure is a line scan camera. Taking the first detection unit 1 in FIG. 4 as an example, when the first side edge 110 of the silicon wafer 100 to be detected enters an edge detection area, the light emitted by the first point light source 11 is first directed to the reflective structure 121 of the first optical path defining element 12, the reflective structure 121 reflects the light to the first side edge 110, the first side edge 110 reflects out the light reflected from the reflective structure 121, the light passes through the slit 122 into the camera 13, and the camera 13 completes image acquisition of the first side edge 110. In this process, the light reflected from the first side edge 110 into the camera 13 has a moderate intensity, so that not only can the imaging of defects on the first side edge 110 be allowed, but the imaging of saw marks on the edge of the silicon wafer itself can also be avoided. In addition, this part of the light has a moderate intensity, so that overexposure is prevented due to excessive illumination, which otherwise affects the imaging effect.

Similarly, when the second side edge 120 of the silicon wafer 100 to be detected enters an edge detection area of the second detection unit 2, the light emitted by the first point light source 21 in the second detection unit 2 is first directed to the reflective structure of the first optical path defining element, the reflective structure reflects the light to the second side edge 120, the second side edge 120 reflects out the light reflected from the reflective structure, the light passes through the slit into the camera 23, and the camera 23 completes image acquisition of the second side edge 120.

By using the reflective structure of the first optical path defining element to reflect the light emitted by the first point light source, reflecting the light to the side edge of the silicon wafer to be detected, and using the slit of the first optical path defining element to receive the light reflected back from the side edge of the silicon wafer to be detected, the light reflected from the side edge of the silicon wafer to be detected passes through the slit into the camera to achieve photographic detection of the side edge of the silicon wafer, so that not only is the problem of an existing square prism affecting an imaging effect solved, but the imaging effect is also improved. Moreover, the mounting of the first optical path defining element is also more convenient than the mounting of the square prism, so that it is more suitable for large-scale industrial use.

FIGS. 1 and 4 illustrates an optional arrangement of the camera 13, the first optical path defining element 12 and the first light source 11 in the first detection unit 1, in which the camera 13 and the first optical path defining element 12 are arranged collinearly, and an optical axis of the camera 13 corresponds to the slit 122; and the first point light source 11 is arranged directly above the reflective structure 121.

Correspondingly, an optional arrangement of the camera 23, the first optical path defining element and the first light source 21 in the second detection unit 2 is also the same as that of the first detection unit 1.

The camera and the first optical path defining element are arranged collinearly, and the optical axis of the camera corresponds to the slit, so that the light reflected from the side edge of the silicon wafer to be detected can linearly pass through the slit into the camera, the imaging effect of the camera can further be improved, and an optical path for the detection is simpler to debug.

The first point light source is arranged directly above the reflective structure, so that the light emitted by the first point light source can be directly directed to the reflective structure without multiple reflections, and the optical path is simpler and easy to mount and debug.

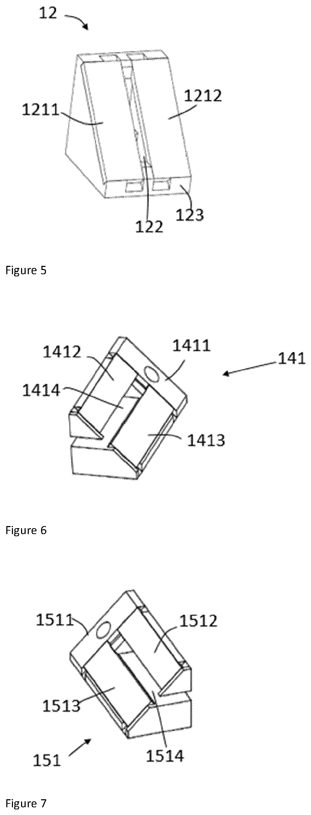

Optionally, as shown in FIG. 5, since the second detection unit 2 and the first detection unit 1 are of the same structure, taking the first optical path defining element 12 in the first detection unit 1 as an example, the first optical path defining element 12 further comprises a first mounting base 123 in an implementation. The first mounting base 123 is in the shape of a right triangular prism, and the reflective structure 121 is fixed to an inclined surface of the first mounting base 123. By designing the first mounting base in the shape of a right triangular prism, not only is the machining facilitated, but fixing the reflective structure to the inclined surface of the first mounting base at a certain angle is also facilitated.

As shown in FIG. 5, the first optical path defining element 12 further has the following implementation that the reflective structure 121 comprises a first reflective structure 1211 and a second reflective structure 1212, and the first reflective structure 1211 and the second reflective structure 1212 are symmetrically fixed on two sides of the slit 122.

The light from the first point light source is reflected by using the first reflective structure and the second reflective structure, so that the light reflected to the side edges of the silicon wafer to be detected can effectively be increased, the side edges can then reflect back more light into the camera through the slit, a better imaging effect can be achieved, and thus a side edge detection effect can be improved.

Furthermore, the first reflective structure and the second reflective structure are symmetrically fixed on the two sides of the slit, so that the utilization rate of the light source can effectively be improved.

Optionally, an inner cavity of the first optical path defining element is a blackened inner cavity, the inner cavity may comprise an inner wall of the slit. The inner wall of the slit mainly refers to all inner surfaces of the slit in the first mounting base.

Specifically, blackening may include applying a black layer to the inner cavity, applying black light absorption cotton, or other similar treatments that can make the inner cavity absorb light.

By blackening the inner cavity of the first optical path defining element, part of the light entering the inner cavity can be absorbed, so as to avoid undesired reflection and refraction of the light in the inner cavity, which otherwise affects the imaging effect.

In an implementation of the silicon wafer detection device, the first detection unit 1 and the second detection unit 2 each further comprise a first chamfer detection assembly and a second chamfer detection assembly, and the first chamfer detection assembly and the second chamfer detection assembly are of the same structure, and are symmetrically arranged relative to the side edge detection assembly.

As shown in FIG. 1, the first chamfer detection assembly 14 and the second chamfer detection assembly 15 of the first detection unit 1 are of the same structure, are symmetrically arranged relative to the side edge detection assembly of the first detection unit 1, and are respectively configured to detect the first chamfer 111 and the second chamfer 112 of the first side edge 110; and
the first chamfer detection assembly 24 and the second chamfer detection assembly 25 of the second detection unit 2 are of the same structure, are symmetrically arranged relative to the side edge detection assembly of the second detection unit 2, and are respectively configured to detect the first chamfer 121 and the second chamfer 122 of the second side edge 120.

Since the first detection unit 1 and the second detection unit 2 are of the same structure, taking the first detection unit 1 as an example, an implementation of the first chamfer detection assembly and the second chamfer detection assembly is described.

The first chamfer detection assembly 14 and the second chamfer detection assembly 15 each comprise a second optical path defining element. As shown in FIGS. 1, 2 and 6, the second optical path defining element 141 of the first chamfer detection assembly 14 comprises a second mounting base 1411, a third reflective structure 1412, a fourth reflective structure 1413 and a channel 1414. The channel 1414 is arranged on the second mounting base 1411 and is configured to provide a conveying channel for the silicon wafer 100 to be detected, and the third reflective structure 1412 and the fourth reflective structure 1413 are fixedly arranged on two sides of the channel 1414 respectively.

As shown in FIGS. 3 and 7, the second optical path defining element 151 of the second chamfer detection assembly 15 comprises a second mounting base 1511, a third reflective structure 1512, a fourth reflective structure 1513 and a channel 1514. The channel 1514 is arranged on the second mounting base 1511 and is configured to provide a conveying channel for the silicon wafer 100 to be detected, and the third reflective structure 1512 and the fourth reflective structure 1513 are fixedly arranged on two sides of the channel 1514 respectively.

Since the second detection unit 2 and the first detection unit 1 are of the same structure, the first chamfer detection assembly 24 and the second chamfer detection assembly 25 in the second detection unit 2 may also use the same structure as that shown in FIGS. 2 and 3, which will not be described in details in the present disclosure.

By providing the chamfer detection assemblies, in addition to the detection of the side edges of the silicon wafer, the silicon wafer side edge detection device of the present disclosure can also detect the chamfers connected to the side edges. The chamfers of the silicon wafer to be detected are detected by using the second optical path defining element having the third reflective structure, the fourth reflective structure and the channel.

Optionally, the first chamfer detection assembly and the second chamfer detection assembly each further comprise a second point light source, the third reflective structure and the fourth reflective structure are configured to reflect light emitted by the respective second point light source and reflect the light to a chamfer of the silicon wafer to be detected, and the light is reflected by the chamfer of the silicon wafer to be detected and passes through the slit into the camera.

Taking the first detection unit 1 as an example, as shown in FIG. 2, the first chamfer detection assembly 14 comprises a second point light source 142, the third reflective structure 1412 and the fourth reflective structure 1413 are configured to reflect light emitted by the second point light source 142 and reflect the light to the chamfer 111 of the silicon wafer 100 to be detected, and the light is reflected by the chamfer of the silicon wafer to be detected and passes through the slit into the camera.

The second point light source is arranged to provide illumination for the third reflective structure and the fourth reflective structure so as to complete the imaging of the chamfers of the silicon wafer to be detected, so that a better imaging effect can be obtained.

Optionally, as shown in FIG. 6, the second mounting base 1411 of the first chamfer detection assembly 14 of the first detection unit 1 is in the shape of a right triangular prism, and the third reflective structure 1412 and the fourth reflective structure 1413 are fixedly arranged on an inclined surface of the second mounting base 1411.

As shown in FIG. 7, the second mounting base 1511 of the second chamfer detection assembly 15 of the first detection unit 1 is in the shape of a right triangular prism, and the third reflective structure 1512 and the fourth reflective structure 1513 are fixedly arranged on an inclined surface of the second mounting base 1511.

Of course, in an optional implementation of the first chamfer detection assembly 24 and the second chamfer detection assembly 25 in the second detection unit 2, the same structure as that shown in FIGS. 6 and 7 may also be used.

By designing the second mounting base to be in the shape of a right triangular prism, not only is the machining facilitated, but fixing the third reflective structure and the fourth reflective structure to the inclined surface of the second mounting base at a certain angle is also facilitated.

Optionally, as shown in FIG. 6, in the second optical path defining element of the first chamfer detection assembly 14 of the first detection unit 1, the channel 1414 is a blind slot or a through slot extending horizontally from the inclined surface of the second mounting base to the interior of the second mounting base 1411.

As shown in FIG. 7, in the second optical path defining element of the second chamfer detection assembly 15 of the first detection unit 1, the channel 1514 is a blind slot or a through slot extending horizontally from the inclined surface of the second mounting base to the interior of the second mounting base 1511.

Of course, the first chamfer detection assembly 24 and the second chamfer detection assembly 25 related to the second detection unit 2 may also use the same structure as that shown in FIGS. 6 and 7.

The blind slot or the through slot extending horizontally from the inclined surface of the second mounting base to the interior of the second mounting base provides a channel for allowing the side edges and the chamfers of the silicon wafer to pass through in the silicon wafer detection process, thus providing a necessary condition for detecting the silicon wafer while the silicon wafer is being moved.

Optionally, the first detection unit 1 and the second detection unit 2 are each adjustable toward or away from the silicon wafer to be detected.

Specifically, the first detection unit 1 is fixedly arranged on a first connecting plate 3, the second detection unit 2 is fixedly arranged on a second connecting plate 4, and the first connecting plate 3 and the second connecting plate 4 are slidably connected to an adjustment track 5. The sliding of the first connecting plate 3 and the second connecting plate 4 may be achieved by using any of an electric motor, a pneumatic cylinder, an electric cylinder, manual adjustment and so on, which is not specifically limited in the present disclosure.

By designing each of the first detection unit 1 and the second detection unit 2 to be adjustable toward or away from the silicon wafer to be detected, not only are mounting and debugging facilitated, but the compatibility with silicon wafers of different sizes is also facilitated.

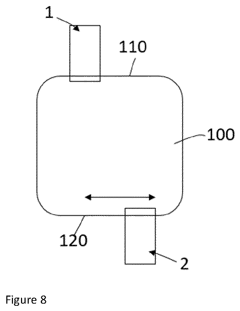

In order to avoid the interference between the respective light sources of the first detection unit 1 and the second detection unit 2, in an optional implementation, as shown in FIG. 8, the first detection unit 1 and the second detection unit 2 may be arranged respectively corresponding to the two mutually parallel side edges of the silicon wafer to be detected (that is, the first side edge 110 and the second side edge 120 that are parallel to each other in the figure), and are distributed in a staggered manner in an extending direction (that is, the direction on the straight line as indicated by the arrows in the figure) of the side edges.

In a second aspect, the present disclosure provides a silicon wafer sorting machine, comprising a silicon wafer side edge detection device as described above and an alignment device, wherein the alignment device is located upstream of the silicon wafer side edge detection device and is configured to pre-align the silicon wafer to be detected that enters the silicon wafer side edge detection device.

Before the side edges of the silicon wafer are detected, the silicon wafer is pre-aligned by using the alignment device, so that the silicon wafer is kept in a preferred positional state when reaching the silicon wafer side edge detection device, so that the effect and efficiency of side edge detection can further be improved, and the overall efficiency of the silicon wafer sorting machine can thus be improved.

The present disclosure and the implementation thereof have been described schematically above, and the description is not restrictive. Only one of the implementations of the present disclosure is shown in the drawings, but the actual structure is not limited thereto. Therefore, with the motivation from the present disclosure, any structural forms and embodiments similar to the technical solution, which are designed by those of ordinary skill in the art without involving any inventive effect and deviating from the essence of the present disclosure, shall all fall within the scope of protection of the present disclosure.

## Claims

1. A silicon wafer side edge detection device, comprising: a first detection unit and a second detection unit, wherein the first detection unit and the second detection unit are of the same structure and are respectively configured to detect two mutually parallel side edges of a silicon wafer; and
the first detection unit and the second detection unit each comprises a side edge detection assembly, the side edge detection assembly comprising a first point light source, a first optical path defining element, and a camera, wherein the first optical path defining element comprises a reflective structure and a slit, the reflective structure is configured to reflect light emitted by the first point light source and reflect the light to a side edge of a silicon wafer to be detected, and the light is reflected by the side edge of the silicon wafer to be detected and passes through the slit into the camera.

2. The silicon wafer side edge detection device according to claim 1, wherein the camera and the first optical path defining element are arranged collinearly, and an optical axis of the camera corresponds to the slit; and the first point light source is arranged directly above the reflective structure.

3. The silicon wafer side edge detection device according to claim 1, wherein the first optical path defining element further comprises a first mounting base in the shape of a right triangular prism, and the reflective structure is fixed to an inclined surface of the first mounting base.

4. The silicon wafer side edge detection device according to claim 1, wherein the reflective structure comprises a first reflective structure and a second reflective structure which are symmetrically fixed on two sides of the slit.

5. The silicon wafer side edge detection device according to claim 1, wherein an inner cavity of the first optical path defining element is a blackened inner cavity, and the inner cavity comprises an inner wall of the slit.

6. The silicon wafer side edge detection device according to claim 1, wherein the first detection unit and the second detection unit each further comprise a first chamfer detection assembly and a second chamfer detection assembly, and the first chamfer detection assembly and the second chamfer detection assembly are of the same structure, and are symmetrically arranged relative to the side edge detection assembly; and
the first chamfer detection assembly and the second chamfer detection assembly each comprise a second optical path defining element, the second optical path defining element comprising a second mounting base, a third reflective structure, a fourth reflective structure and a channel, wherein the channel is arranged on the second mounting base and is configured to provide a conveying channel for the silicon wafer to be detected, and the third reflective structure and the fourth reflective structure are fixedly arranged on two sides of the channel respectively.

7. The silicon wafer side edge detection device according to claim 6, wherein the first chamfer detection assembly and the second chamfer detection assembly each further comprise a second point light source, the third reflective structure and the fourth reflective structure are configured to reflect light emitted by the respective second point light source and reflect the light to a chamfer of the silicon wafer to be detected, and the light is reflected by the chamfer of the silicon wafer to be detected and passes through the slit into the camera.

8. The silicon wafer side edge detection device according to claim 6, wherein the second mounting base is in the shape of a right triangular prism, and the third reflective structure and the fourth reflective structure are fixedly arranged on an inclined surface of the second mounting base.

9. The silicon wafer side edge detection device according to claim 6, wherein the channel is a blind slot or a through slot extending horizontally from the inclined surface of the second mounting base to the interior of the second mounting base.

10. The silicon wafer side edge detection device according to claim 1, wherein the first detection unit and the second detection unit are each adjustable toward or away from the silicon wafer to be detected.

11. The silicon wafer side edge detection device according to claim 1, wherein the first detection unit and the second detection unit are respectively arranged corresponding to the two mutually parallel side edges of the silicon wafer to be detected, and are distributed in a staggered manner in an extending direction of the side edges.

12. A silicon wafer sorting machine, comprising a silicon wafer side edge detection device of any one of claims 1-11 and an alignment device, wherein the alignment device is located upstream of the silicon wafer side edge detection device and is configured to pre-align the silicon wafer to be detected that enters the silicon wafer side edge detection device.
